(19) **Europäisches Patentamt**
**European Patent Office**
**Office européen des brevets**

(11) **EP 1 297 617 B1**

(12) **EUROPEAN PATENT SPECIFICATION**

(45) Date of publication and mention
of the grant of the patent:
**19.03.2008 Bulletin 2008/12**

(51) Int Cl.:
***H03C 3/09*** (2006.01)

(21) Application number: **01940864.0**

(86) International application number:
**PCT/IB2001/000593**

(22) Date of filing: **09.04.2001**

(87) International publication number:
**WO 2001/078227 (18.10.2001 Gazette 2001/42)**

(54) **FREQUENCY MODULATOR USING A PLL**

FREQUENZMODULATOR UNTER VERWENDUNG EINES PHASENREGELKREISES

OSCILLATEUR A FREQUENCE COMMANDEE AVEC STABILISATION DU GAIN BASSE TENSION

(84) Designated Contracting States:
**AT BE CH CY DE DK ES FI FR GB GR IE IT LI LU MC NL PT SE TR**

(30) Priority: **07.04.2000 GB 0008695**

(43) Date of publication of application:
**02.04.2003 Bulletin 2003/14**

(73) Proprietor: **MOTOROLA ISRAEL LIMITED**
**67899 Tel Aviv (IL)**

(72) Inventors:
• **BEN-AYUN, Moshe**
**Shoham (IL)**
• **ROZENTAL, Mark**
**76560 Rehovot (IL)**

• **ZILBERMAN, Nir**
**76560 Rehovot (IL)**

(74) Representative: **McCormack, Derek James**
**Optimus**
**Grove House, Lutyens Close,**
**Chineham Court,**
**Basingstoke,**
**Hampshire RG24 8AG (GB)**

(56) References cited:
**DE-A- 3 447 118      GB-A- 2 338 128**
**US-A- 4 074 209      US-A- 4 378 534**
**US-A- 4 510 465      US-A- 4 721 927**
**US-A- 4 904 964**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

Field Of The Invention

The present invention relates to tunable phase locked loop systems in general, and to systems which include a voltage controlled oscillator, in particular.

Background Of The Invention

Frequency synthesizer phase locked loops are widely used in communication transceivers. These loops typically include a voltage-controlled oscillator (VCO). In these conventional techniques, voltage controlled capacitors (varactors), are usually used to vary the resonant frequency of the VCO tuning network in accordance with a control voltage. The varactor has significantly non-linear response to applied voltage, especially at low voltages. Such a behavior leads to the use of high varactor control voltages, typically 12 Volts or more, to achieve the VCO tuning range that is needed for feedback transceiver applications.

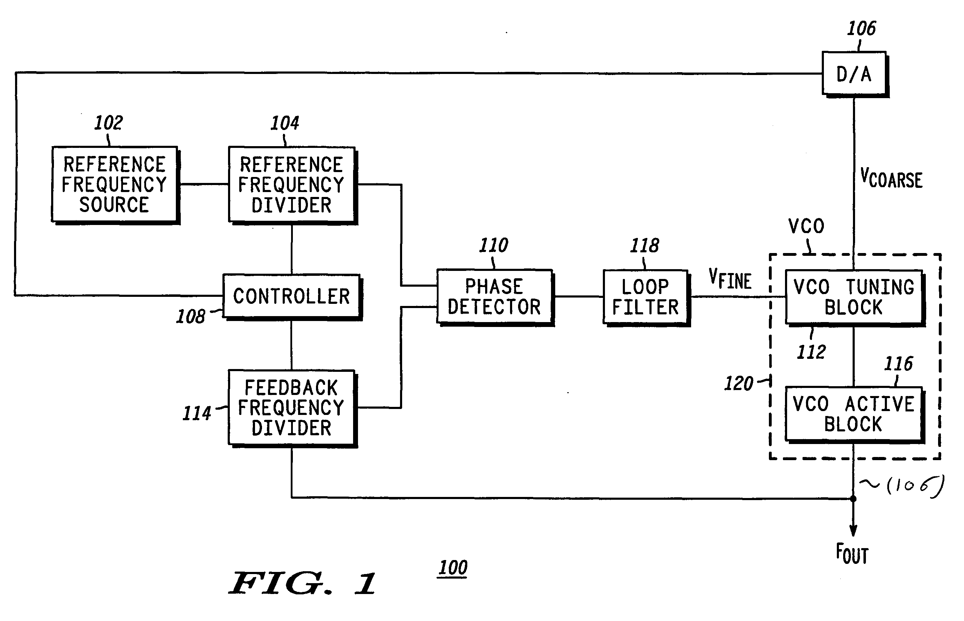

Reference is now made to Figure 1, which is a schematic illustration of a conventional phase locked loop frequency synthesizer, generally referenced 100. Frequency synthesizer 100 includes a reference frequency source 102, a reference frequency divider 104, a digital-to-analog converter (DAC) 106, a controller 108, a phase detector 110, a loop filter 118, a VCO 120 and a feedback frequency divider 114. VCO 120 further includes a VCO tuning block 112 and a VCO active block 116.

Reference frequency divider 104 is coupled to reference frequency source 102, controller 108 and phase detector 110. Feedback frequency divider 114 is coupled to phase detector 110, controller 108 and VCO active block 116. Loop filter 118 is coupled to phase detector 110 and to VCO tuning block 112. DAC 106 is coupled to VCO tuning block 112 and to controller 108. VCO active block 116 is coupled to VCO tuning block 112 and to feedback frequency divider 114.

Reference frequency divider 104 receives a signal, having the frequency $F_R$, from frequency source 102. Reference frequency divider 104 further divides this signal by N and provides the resultant signal, having the frequency $F_R/N$, to phase detector 110. Feedback frequency divider 114 receives a feedback signal, having the output frequency $F_{OUT}$, from VCO active block 116. Feedback frequency divider 114 further divides this signal by M and provides the resultant signal, having the frequency $F_{OUT}/M$, to phase detector 110. Phase detector 110 compares these two signals, generates a respective output control signal and provides it to loop filter 118. Typically, loop filter 118 is a low-pass filter. It integrates the output control signal and provides the resultant output voltage $V_{FINE}$ to VCO tuning block 112. Depending on the value of $V_{FINE}$, VCO tuning block 112 adjusts the output frequency $F_{OUT}$ so that it would be equal to the desired value $\dfrac{M}{N} \cdot F_R$. This adjustment is performed within a comparatively narrow frequency range (fine-tuning). For a coarse tuning within a wide frequency range, DAC 106 provides a respective control signal $V_{COARSE}$ to VCO tuning block 112.

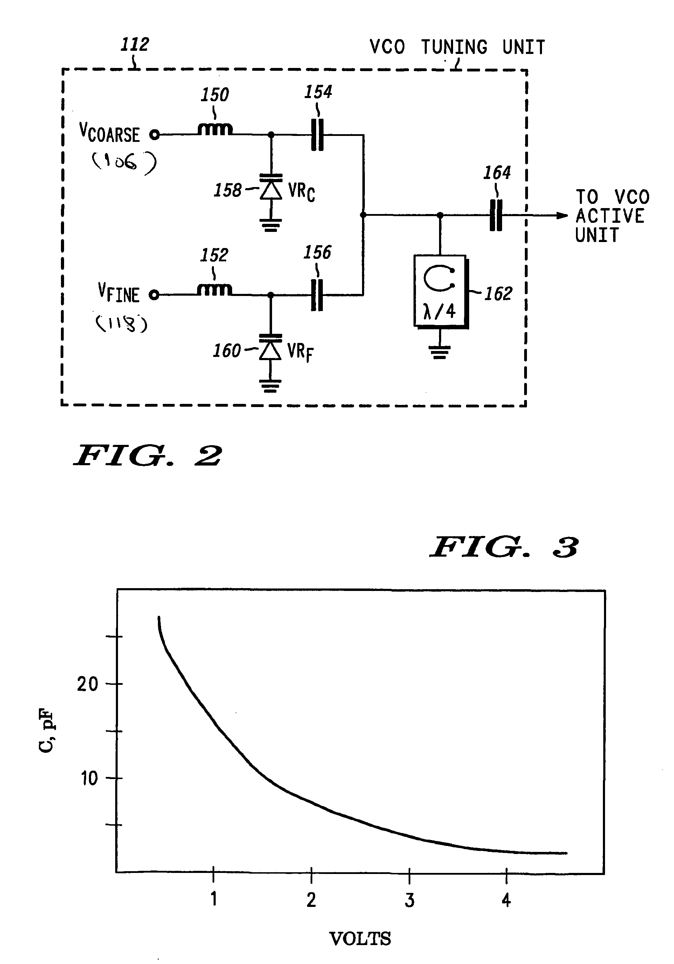

Reference is now made to Figure 2, which is a schematic illustration in detail of a conventional VCO tuning block 112 of Figure 1. VCO tuning block 112 includes two inductors 150 and 152, a first varactor $VR_C$ 158, a second varactor $VR_F$ 160, three capacitors 154, 156 and 164 and a resonator 162.

Varactor $VR_C$ 158 is coupled to inductor 150 and capacitor 154. Varactor $VR_F$ 160 is coupled to inductance 152 and capacitor 156. Resonator 162 is coupled to capacitors 154, 156 and 164.

A varactor is a voltage-controlled diode whose capacitance changes with applied voltage. The character of this change is non-linear.

Reference is now made to Figure 3, which is a graphical illustration of a typical dependence of varactor capacitance on applied voltage. At low voltages (for example, between 0.5 Volts and 1.5 Volts) the capacitance is maximal (for example, between 15 pF and 25 pF) and at high voltages (for example between 3.5 Volts and 4.5 Volts) the capacitance is minimal (for example, between 2 pF and 3 pF). Varactor voltage sensitivity, which is a derivative of varactor capacitance with respect to applied voltage, also changes in a non-linear manner. The voltage sensitivity of the varactor is much higher for the lower values of applied voltage than for the higher values of applied voltage.

Referring back to Figure 2, the capacitance of varactor $VR_C$ 158 is controlled by the voltage provided by DAC 106 of Figure 1 via inductor 150. This steering voltage is responsible for a coarse tuning. The capacitance of varactor $VR_F$ 160 is controlled by the output voltage $V_{FINE}$, provided by loop filter 118 of Figure 1. The output voltage $V_{FINE}$ is provided to varactor 160 via inductor 152. The output control signal executes a fine tuning of the VCO. Since a VCO operating frequency is inversely proportional to the varactor capacitance, VCO sensitivity is much greater at low operating frequencies than at high operating frequencies. In order to increase the operating frequency range while keeping the VCO sensitivity at a low level, known devices use comparatively high voltages for VCO tuning (up to 13 Volts).

New generations of IC for portable communication devices are based on low-voltage elements (3 - 5 Volts maximum). According to the foregoing explanation, variations of the control voltage within 5 Volts range will lead to a reduction of the operation frequency bandwidth and to large variations of the VCO gain. It is therefore desirable to have a low-voltage VCO circuit with varactors, which will provide the required operating frequency range and low VCO sensitivity.

Prior art published United Kingdom patent application GB-A-2,338,128 shows a voltage controlled oscillator. GB-A-2,338,128 describes a method for flattening the frequency modulation deviation over the frequency range of the VCO. This invention can be used in radio transmitters that use FM modulation and directly modulate the VCO.

Prior art published United States patent US-A-4,003,004 is concerned with getting a linear response to the FM modulating signal from the VCO. Referring to figure 1, the modulation signal goes through modulation FET amplifier 50 to the varactors 30/32, thus FM modulating the VCO. FET amplifier response is compensating for varactor nonlinearity and the response to the modulation signal is linear.

US-A-4,904,964 describes a VCO wherein a control voltage is utilised for modulation compensation by a modulation compensation network. The method described in US-A-4,904,964 is aimed at use in a frequency modulated transmitter wherein an audio signal modulates the VCO. The method allows FM deviation to be flattened over the frequency range of the VCO. In US-A-4,904,964 a resonator of the VCO is described which includes a varactor whose cathode is connected to a control voltage input obtained from a phase locked loop. The invention now to be described is not disclosed or suggested in US-A-4,904,964.

Summary of the present invention

It is an object of the present invention to provide a novel system, which includes voltage-controlled oscillator (VCO) with low-voltage gain stabilization, which mitigates the disadvantages of the prior art.

It is another object of the present invention to provide a VCO with small gain variations in response to variations of the control voltage for coarse tuning.

In accordance with the present invention in a first aspect , there is thus provided a voltage controlled oscillator (VCO) circuit as defined in claim 1 of the accompanying claims.

The VCO circuit according to the invention may include a voltage source for applying to the second tuning element a voltage which opposes the external control voltage applied thereto whereby when the external control voltage increases the overall voltage across the second tuning element decreases.

The tuning parameter of each of the tuning elements is desirably a capacitance, the capacitance of each tuning element varying within a predetermined range in response to a control voltage applied thereto. The capacitance of each of said tuning elements may depend non-linearly on the respective control voltage applied across the element. The tuning elements are preferable varactors.

According to the present invention in a second aspect a phase locked loop (PLL) circuit for a frequency synthesizer includes a VCO circuit according to first aspect and a phase detector for comparing a phase of a reference signal with a phase of an output VCO signal from the VCO circuit, the phase detector generating an output signal for a fine VCO tuning, the output signal being responsive to the difference between the phases of the reference signal and the output VCO signal, the PLL further including a controller, and a control voltage source, the controller being coupled to the input of the control voltage source, the control voltage source generating a control voltage for the coarse VCO tuning at the output, the control voltage being responsive to commands from the controller.

Embodiments of the present invention will now be described with reference to the accompanying drawings, in which:

Brief Description Of The Drawings

The present invention will be understood and appreciated more fully from the following detailed description taken in conjunction with the drawings in which:

Figure 1 is a schematic illustration of a prior art phase locked loop frequency synthesizer;
Figure 2 is a schematic illustration in detail of VCO tuning block of Figure 1;
Figure 3 is a graphical illustration of a prior art typical dependence of varactor capacitance on applied voltage;
Figure 4 is a schematic illustration of a VCO tuning block, constructed and operative in accordance with a preferred embodiment of the present invention; and
Figure 5 is a graphical illustration of a typical dependence of the capacitance of varactor $VR_1$ 214 of Figure 4 on applied voltage.

Detailed Description Of Preferred Embodiments

The present invention mitigates the disadvantages of the prior art by providing a tunable VCO, which requires low control voltage values to provide a wideband control range.

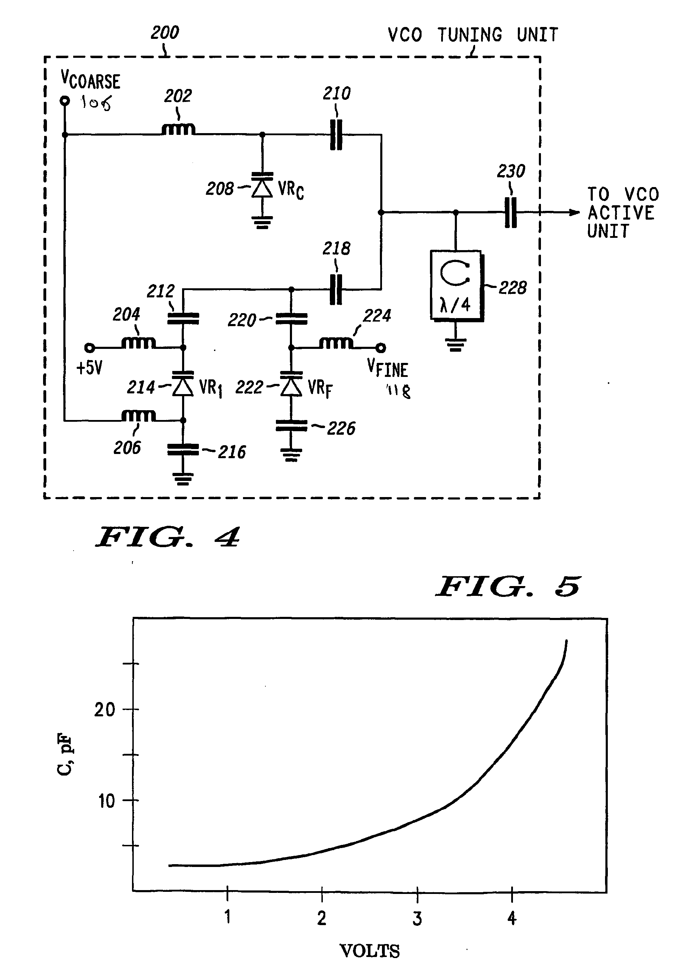

Reference is now made to Figure 4, which is a schematic illustration of a VCO tuning block, generally referenced 200, constructed and operative in accordance with a preferred embodiment of the present invention. VCO tuning block 200 includes four inductors 202, 204, 206 and 224, seven capacitors 210, 212, 216, 218, 220, 226 and 230, a first varactor $VR_C$ 208, a second varactor $VR_1$ 214, a third varactor $VR_F$ 222, and a resonator 228.

Varactor $VR_C$ 208 is coupled to inductor 202 and capacitor 210. Varactor $VR_1$ 214 is coupled to inductors 204 and 206 and to capacitors 212 and 216. Varactor $VR_F$ 222 is coupled to inductor 224 and to capacitors 220 and 226. Capacitor 218 is coupled to capacitors 220, 230, 212 and 210, and to resonator 228. Inductor 206 is coupled to inductor 202.

DAC 106 of Figure 1 provides $V_{COARSE}$ voltage to varactor $VR_C$ 208, via inductor 202, and to varactor $VR_1$ 214 via inductor 206. According a to preferred embodiment of the present invention, additional bias voltage (for example, +5V) is applied to varactor $VR_1$ 214. In this case the capacitance of varactor $VR_1$ 214 changes with the applied voltage $V_{COARSE}$ in a manner, which is opposite to that of varactor $VR_C$ 208.

Reference is now made to Figure 5, which is a graphical illustration of a typical dependence of the capacitance of varactor $VR_1$ 214 of Figure 4 on applied voltage. In contrast to the dependence, which was presented in Figure 3, the capacitance of varactor $VR_1$ 214, as well as its sensitivity, are minimal for low $V_{COARSE}$ values and maximal for high $V_{COARSE}$ values.

Referring back to Figure 4, the capacitance of varactor $VR_C$ 208 is high and the capacitance of varactor $VR_1$ 214 is low when $V_{COARSE}$ is low. In an opposite case where the value of $V_{COARSE}$ is high, then, the capacitance of varactor $VR_C$ 208 is low and the capacitance of varactor $VR_1$ 214 is high. Thus, the resulting change of the capacitance, as well as that of the VCO sensitivity, over the entire range of $V_{COARSE}$ variations, is small. This allows applying comparatively low voltages (up to 5 Volts) for controlling VCO operating frequency over a wide frequency range, while keeping low VCO sensitivity.

Returning now to a consideration of the prior art documents cited earlier, it is notable that the present invention provides the possibility of designing a wideband VCO, while keeping the VCO gain constant and small. The present invention is not intended to be used for flattening the FM deviation, as was the arrangement of GB-A-2338128.

Here, reference is made to Figure 4 in GB-A-2338128 and to Figure 4 in the present invention. Vsteer in GB-A-2338128 corresponds to Vfine in the present invention. This is the line that is connected to the Loop Filter, and via this line, the phase locked loop is steering the VCO. The purpose of the present invention is to make the VCO sensitivity to this steering line as small as desired, and constant across the VCO frequency band. The purpose of GB-A-2338128 is to keep the VCO response to the audio modulation signal flat over the VCO frequency range. GB-A-2338128 does not keep VCO gain (dF/dVsteer) low and constant. Vcoarse in the present invention is controlling the VCO banding, and, at the same time, contributes to VCO gain flatness via the VR1 arrangement. Note that Vcoarse is a DC voltage. The VR1 (214) arrangement allows the present invention to get complementary varactor response as shown in figure 5 of the appended drawings. In summary, the present invention is completely different from GB-A-2338128, both in it's objectives and in how the invention works.

The present invention differs from the arrangement of US 4,003,004. The present invention achieves small and constant VCO gain over the VCO frequency range. The objective of the present invention is therefore different from US 4,003,004.

It will be appreciated by persons skilled in the art that the present invention is not limited to what has been particularly shown and described hereinabove. The scope of the present invention is defined only by the appended claims.

## Claims

1. A voltage controlled oscillator circuit (200) comprising:

   a resonator (228);
   a plurality of tuning elements (208, 214) coupled in parallel to said resonator;
   a plurality of input ports (106, 118), each one of the tuning elements being coupled to a selected one of said input ports, each said input port being arranged to receive in operation a predetermined external control voltage;
   wherein each of said tuning elements comprises a voltage controlled device which varies a tuning parameter of the resonator;
   wherein a first tuning element (208) is arranged such that the tuning parameter provided thereby decreases with increasing applied external control voltage and a second tuning element (214) is arranged such that the tuning parameter provided thereby increases with increasing applied external control voltage,
   and **characterised in that** the first tuning element (208) and the second tuning element (214) are coupled to a first (106) of the input ports to receive a coarse control voltage ($V_{COARSE}$) from the first input port and the circuit (200) includes a third tuning element (222) coupled in parallel with the first tuning element and the second tuning element to the resonator, the third tuning element comprising a voltage controlled device which varies a tuning parameter of the resonator, the third tuning element being coupled to a second (118) of the input ports to receive a fine control voltage from the second input port.

2. A voltage controlled oscillator circuit according to claim 1 wherein the third tuning element is operable such that a tuning parameter provided thereby decreases with increasing applied external control voltage

3. A voltage controlled oscillator circuit according to claim 1 or claim 2 and including a voltage source (+5V) for applying to the second tuning element a voltage which opposes the external control voltage applied thereto whereby when the external control voltage increases the overall voltage across the second tuning element decreases.

4. A voltage controlled oscillator circuit according to any one of claims 1 to 3, wherein the tuning parameter of each of the tuning elemnts is a capacitance, the capacitance of each tuning element varying within a predetermined range in response to a control voltage applied thereto.

5. A voltage controlled oscillator circuit according to claim 4, wherein the capacitance of each of said tuning elements depends non-linearly with the respective control voltage applied across the element.

6. A voltage controlled oscillator circuit according to claim 4 or claim 5, wherein the tuning elements are varactors.

7. A phase locked loop circuit for a frequency synthesizer, the phase locked loop circuit including a voltage controlled oscillator circuit according to any one of the preceding claims and a phase detector for comparing a phase of a reference signal with a phase of an output signal from the voltage cotrolled oscillator circuit, the phase detector being operable to generate an output voltage signal for a fine tuning of the voltage controlled oscillator circuit, the output voltage signal being responsive to the difference between the phases of the reference signal and the output signal, the phase locked loop circuit further including a controller and a control voltage source, the controller being coupled to the input of the control voltage source, the control voltage source generating a control voltage for coarse tuning of the voltage controlled oscillator circuit, the control voltage being responsive to commands from the controller.

**Patentansprüche**

1. Spannungsgesteuerte Oszillatorschaltung (200), die umfasst:

einen Resonator (228);
eine Mehrzahl von Abstimmelementen (208, 214), die mit dem Resonator parallelgeschaltet sind;
eine Mehrzahl von Eingangsanschlüssen (106, 118), wobei jedes der Abstimmelemente an einen ausgewählten der Eingangsanschlüsse angeschlossen ist, wobei jeder der Eingangsanschlüsse angeordnet ist, um unter Betriebsbedingungen eine vorbestimmte externe Steuerspannung zu empfangen;
wobei jedes der Abstimmelemente eine spannungsgesteuerte Vorrichtung umfasst, die einen Abstimmparameter des Resonators variiert;

wobei ein erstes Abstimmelement (208) so angeordnet ist, dass der dadurch zur Verfügung gestellte Abstimmparameter mit einer zugeführten zunehmenden externen Steuerspannung abnimmt und ein zweites Abstimmelement (214) so angeordnet ist, dass der dadurch zur Verfügung gestellte Parameter mit einer zugeführten zunehmenden externen Steuerspannung zunimmt,

und **dadurch gekennzeichnet, dass** das erste Abstimmelement (208) und das zweite Abstimmelement (214) an einen ersten (106) der Eingangsanschlüsse angeschlossen sind, um von dem ersten Eingangsanschluss eine grobe Steuerspannung (V$_{COARSE}$) zu empfangen, und die Schaltung (200) ein drittes Abstimmelement (222) umfasst, das mit dem ersten Abstimmelement und dem zweiten Abstimmelement in Parallelschaltung an den Resonator angeschlossen ist, wobei das dritte Abstimmelement eine spannungsgesteuerte Vorrichtung umfasst, die einen Abstimmparameter des Resonators variiert, wobei das dritte Abstimmelement an einen zweiten (118) der Eingangsanschlüsse angeschlossen ist, um von dem zweiten Eingangsanschluss eine Feinsteuerungsspannung zu empfangen.

2. Spannungsgesteuerte Oszillatorschaltung gemäß Anspruch 1, wobei das dritte Abstimmelement so betreibbar ist, dass ein dadurch zur Verfügung gestellter Abstimmparameter mit einer zugeführten zunehmenden externen Steuerspannung abnimmt.

3. Spannungsgesteuerte Oszillatorschaltung gemäß Anspruch 1 oder Anspruch 2, die eine Spannungsquelle (+5V) umfasst, um dem zweiten Abstimmelement eine Spannung zuzuführen, die sich der dem zweiten Abstimmelement zugeführten Steuerspannung entgegenstellt, wodurch die Gesamtspannung über dem zweiten Abstimmelement abnimmt, wenn die externe Steuerspannung zunimmt.

4. Spannungsgesteuerte Oszillatorschaltung gemäß einem der Ansprüche 1 bis 3, wobei der Abstimmparameter eines jeden der Abstimmelemente eine Kapazität ist, wobei die Kapazität eines jeden Abstimmelementes in Reaktion auf eine dem Abstimmelement zugeführte Steuerspannung innerhalb eines vorbestimmten Bereiches variiert.

5. Spannungsgesteuerte Oszillatorschaltung gemäß Anspruch 4, wobei die Kapazität eines jeden der Abstimmelemente in nicht-linearer Weise auf der jeweiligen über das Element zugeführten jeweiligen Steuerspannung beruht.

6. Spannungsgesteuerte Oszillatorschaltung gemäß Anspruch 4 oder Anspruch 5, wobei die Abstimmelemente Varaktoren sind.

7. Phase-Locked-Loop-Schaltung für einen Frequenzgenerator, wobei die Phase-Locked-Loop-Schaltung eine spannungsgesteuerte Oszillatorschaltung gemäß einem der vorangehenden Ansprüche und einen Phasendetektor zum Vergleichen einer Phase eines Referenzsignals und einer Phase eines Ausgangssignals von der spannungsgesteuerten Oszillatorschaltung umfasst, wobei der Phasendetektor betreibbar ist, um ein Ausgangsspannungssignal für eine Feinsteuerung der spannungsgesteuerten Oszillatorschaltung zu erzeugen, wobei das Ausgangsspannungssignal auf den Unterschied zwischen den Phasen des Referenzsignals und des Ausgangssignals anspricht, wobei die Phase-Locked-Loop-Schaltung weiterhin eine Steuerung und eine Steuerspannungsquelle umfasst, wobei die Steuerung an den Eingang der Steuerspannungsquelle gekoppelt ist, wobei die Steuerspannungsquelle eine Steuerspannung für eine grobe Abstimmung der spannungsgesteuerten Oszillatorschaltung erzeugt, wobei die Steuerspannung auf Anweisungen von der Steuerung anspricht.

**Revendications**

1. Circuit oscillateur commandé en tension (200) comprenant :

un résonateur (228) ;
une pluralité d'éléments d'accord (208, 214) couplés en parallèle audit résonateur ;
une pluralité de ports d'entrée (106, 118), chacun des éléments d'accord étant couplé à l'un sélectionné desdits ports d'entrée, chacun desdits ports d'entrée étant conçu pour recevoir, en utilisation, une tension de commande externe prédéterminée ;
dans lequel chacun desdits éléments d'accord comprend un dispositif commandé en tension qui fait varier un paramètre d'accord du résonateur ;
dans lequel un premier élément d'accord (208) est conçu de telle sorte que le paramètre d'accord résultant de l'opération diminue avec l'augmentation de la tension de commande externe appliquée, et un deuxième élément d'accord (214) est conçu de telle sorte que le paramètre d'accord résultant de l'opération augmente avec l'augmentation de la tension de commande externe appliquée,
et **caractérisé en ce que** le premier élément d'accord (208) et le deuxième élément d'accord (214) sont couplés à un premier (106) des ports d'entrée de façon à recevoir une tension de commande grossière ($V_{COARSE}$) par le premier port d'entrée, et le circuit (200) comprend un troisième élément d'accord (222) couplé au résonateur, en parallèle avec le premier élément d'accord et le deuxième élément d'accord, le troisième élément d'accord comprenant un dispositif commandé en tension qui faire varier un paramètre d'accord du résonateur, le troisième élément d'accord étant couplé à un deuxième (118) des ports d'entrée de façon à recevoir une tension de commande fine par le deuxième port d'entrée.

2. Circuit oscillateur commandé en tension selon la revendication 1, dans lequel le troisième élément d'accord fonctionne de telle sorte qu'un paramètre d'accord résultant de l'opération diminue avec l'augmentation de la tension de commande externe appliquée.

3. Circuit oscillateur commandé en tension selon la revendication 1 ou la revendication 2, et comprenant une source de tension (+5V) pour appliquer au deuxième élément d'accord une tension qui s'oppose à la tension de commande externe qui y est appliquée, de façon que lorsque la tension de commande externe augmente la tension globale aux bornes du deuxième élément d'accord diminue.

4. Circuit oscillateur commandé en tension selon l'une quelconque des revendications 1 à 3, dans lequel le paramètre d'accord de chacun des éléments d'accord est une capacité, la capacité de chaque élément d'accord variant dans une plage prédéterminée en réponse à une tension de commande qui y est appliquée.

5. Circuit oscillateur commandé en tension selon la revendication 4, dans lequel la capacité de chacun desdits éléments d'accord dépend d'une manière non linéaire de la tension de commande respective appliquée aux bornes de l'élément en question.

6. Circuit oscillateur commandé en tension selon la revendication 4 ou la revendication 5, dans lequel les éléments d'accord sont des varactors.

7. Circuit de boucle à verrouillage de phase pour un synthétiseur de fréquence, le circuit de boucle à verrouillage de phase comprenant un circuit oscillateur commandé en tension selon l'une quelconque des revendications précédentes et un détecteur de phase pour comparer une phase d'un signal de référence à une phase d'un signal de sortie du circuit oscillateur commandé en tension, le détecteur de phase fonctionnant de façon à générer un signal de tension de sortie pour un accord fin du circuit oscillateur commandé en tension, le signal de tension de sortie réagissant à la différence entre les phases du signal de référence et du signal de sortie, le circuit de boucle à verrouillage de phase comprenant, en outre, une unité de commande et une source de tension de commande, l'unité de commande étant couplée à l'entrée de la source de tension de commande, la source de tension de commande générant une tension de commande pour un accord grossier du circuit oscillateur commandé en tension, la tension de commande réagissant aux instructions provenant de l'unité de commande.

**FIG. 1**  <u>100</u>

EP 1 297 617 B1

VCO TUNING UNIT

**FIG. 2**

**FIG. 3**

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2338128 A
- US 4003004 A
- US 4904964 A